# EUROPEAN PATENT APPLICATION

(11) **EP 2 660 586 A2**
(43) Date of publication of application: **06.11.2013**
(21) Application number: 11852270.5
(22) Date of filing: 20.12.2011
(51) Int. Cl.: G01N 21/88, G01B 11/24, H05K 13/08

(54) **VISUAL INSPECTION APPARATUS**

(30) Priority: 30.12.2010 KR 20100138460
(71) Applicant: Mer Skilful Feat Co., Ltd, Gunpo-si, Gyeonggi-do 435-776 (KR)
(72) Inventor: LEE, Hyun Yul, Gunpo-si Gyeonggi-do 435-776 (KR); KANG, Kun Hyung, Gunpo-si Gyeonggi-do 435-776 (KR); PARK, Tae Koang, Gunpo-si Gyeonggi-do 435-776 (KR)
(74) Representative: Gille Hrabal
(86) International application number: PCT/KR2011/009851
(87) International publication number: WO 2012/091344

(57) **Abstract**

The present invention relates to a visual inspection apparatus. The visual inspection apparatus is an apparatus which photographs an inspection object using a camera to determine whether the inspection object is defective or not. The vision inspection apparatus comprises: a stage part on which an inspection object is seated; a camera part including a lens and an image detection part, wherein the camera part photographs an image of the inspection object; an illumination part for illuminating the inspection object; and a visual processing part that reads the image photographed by the camera part to determine whether the inspection object is defective or not. Within a lateral camera of the camera part, which is slopingly installed with respect to a line perpendicular to a plane on which the inspection object is seated, a surface of the image detection part is slopingly installed at a predetermined angle with respect to a plane perpendicular to a line of connecting a center of the inspection object to a center of the camera lens of the lateral camera. Thus, since resolution may be improved and the optical path difference is compensated for, the image of the inspection object may be precisely read. Also, a lateral image of the inspection object may be clearly photographed without changing the size of the apparatus.

## Description

### Technical Field

The present invention relates to a visual inspection apparatus. More specifically, the present invention relates to a visual inspection apparatus constituted to compensate for an optical path difference with respect to an inspection object by slopingly placing an optical sensing unit within a lateral camera part included in the visual inspection apparatus.

### Background Art

In general, a surface mounting technology SMT of assembling a surface mounting components in a printed circuit board PCB and the like includes a technology for miniaturization/integration of a surface mounting device SMD, a development of precision assembly equipments of exactly assembling these surface mount devices, and a technology of operating various assembly equipments.

Typically, a surface mounting line consists of a surface mounting apparatus and an equipment such as a visual inspection apparatus.

The surface mounting apparatus is an equipment for mounting the surface mounting device on the printed circuit board PCB. Various surface mounting devices, which are supplied in the form of tapes, sticks and trays, are supplied by feeders and it perform a task to put the surface mounting devices on a mounting position of the printed circuit board.

In addition, the visual inspection apparatus checks out the mounting status of the surface mounting device prior to or after the completion of the soldering process of the surface mounting device and the printed circuit board is transferred to the next process depending on the result of the process.

In this case, in the conventional method of the visual inspection, it adjusts the initial position in a position control system when the printed circuit board, in that the soldering process is completed through the conveyor, is transferred in horizontal. After the adjustment thereof is completed, a camera takes a photograph of the soldering parts of the surface mounting device when the lighting is irradiated on the printed circuit board.

Thereafter, the visual inspection apparatus outputs the status of the soldering parts through the monitor to be calculated, so that it checks out whether the mounting status is good or not or whether the surface mounting device is mounted or not.

Typically, the visual inspection apparatus detects a distortion degree of a shadow pattern by lighting the shadow pattern of a grid shape on the inspection object, thereby measuring a three-dimensional height of the inspection object.

Thus, the visual inspection apparatus includes a vertical camera arranged on a vertical upper part of a surface, on which the inspection object is placed, for taking a picture of a two-dimensional image of the inspection object and a lateral camera part slopingly placed on a side portion of the inspection object for taking a picture of a modified shape of the shadow pattern of showing on the inspection object.

However, the far side among the edges of the inspection object from the lateral camera part has a longer optical path than the center of the inspection object and the near side among the edges of the inspection object from the lateral camera part has a shorter optical path than the center of the inspection object, so that image focusing position of the upper surface thereof may be different, and this difference is more increased at the wide inspection area thereof.

In order to solve this matter, a deep depth of focus should be secured so that the image of the entire area can be photographed uniformly.

As described above, the difference of the depth of focus required for precisely taking a picture of both edges of the inspection object is increased in a case that the lateral camera part is placed closely to a stage part on which the inspection object is seated, i.e., the lateral camera part is arranged far away from the vertical camera.

On account of this phenomenon, it is necessary to increase the size of the depth of focus to be secured so as to photograph the entire inspection object. However, where the depth of focus is increased according to the properties of the camera, the F value is increased and the aperture thereof is narrowed, resulting in a dark image. After all, there is a problem in that the resolution thereof is deteriorated.

As described above, if the resolution is poor, there is limited to determine the exact three-dimensional shape of fine pattern or small parts.

### Disclosure

### Technical Problem

Accordingly, the present invention has been made to solve the above-mentioned problems occurring in the prior art, and an object of the present invention is to provide a visual inspection apparatus capable of exactly photographing and reading the image owing to a high resolution by compensating for an optical path difference about an inspection object.

Another object of the present invention is to provide a visual inspection apparatus which is configured to ensure clear images of the inspection object without changing the size of the apparatus.

### Technical solution

In order to accomplish this object, there is provided a visual inspection apparatus which photographs an inspection object through a camera to determine whether the inspection object is defective or not, comprising: a stage part on which an inspection object is seated; a camera part including a lens and an image detection part, wherein the camera part photographs an image of the inspection object; an illumination part for illuminating the inspection object; and a visual processing part that reads the image photographed by the camera part to determine whether the inspection object is defective or not, wherein, within a lateral camera of the camera part, which is slopingly installed with respect to a line perpendicular to a plane on which the inspection object is seated, a surface of the image detection part is slopingly installed at a predetermined angle with respect to a plane perpendicular to a line of connecting a center of the inspection object to a center of the camera lens of the lateral camera.

Here, with respect to a side end portion of the inspection object placed on a side closer than the distance from the center Lo of the camera lens, a side end portion Cb of the image detection part is constituted to be placed more closely from the center Lo of the camera lens.

Also, where an angle of a line of connecting a center of the camera lens in the lateral camera to a center of the inspection object with respect to a plane, on which the inspection object is seated, becomes smaller, the image detection part is slopingly installed in larger angle with respect to a line of connecting the center of the camera lens in the lateral camera to the center of the inspection object.

Preferably, the image detection part is slopingly installed at more than 2 degrees and less than 20 degrees with respect to a line of connecting a center of the camera lens in the lateral camera to a center of the inspection object.

### Advantageous Effects

According to the present invention, it is possible to precisely read the images owing to the high resolution by compensating for the optical path difference about the inspection object.

In addition, the precise images of the inspection object can be secured without changing the size of the apparatus.

### Brief Description of the Drawings

The above and other objects, features and advantages of the present invention will be more apparent from the following detailed description taken in conjunction with the accompanying drawings, in which:
FIG. 1 is a schematic view of a visual inspection apparatus according to the present invention;
FIG. 2 is a conceptual view to describe the principle of the present invention;
FIG. 3 is an example view of the image captured by the conventional visual inspection apparatus; and
FIG. 4 is an example view of the image captured by the visual inspection apparatus according to the present invention.

### Best Mode

### Mode for Invention

Hereinafter, an exemplary embodiment of the present invention will be described in detail with reference to the accompanying drawings.

Prior to this, the terms used in the present specification and claims are not limited to the terms used in the dictionary sense. On the basis of the principle that the inventor can define the appropriate concept of the term in order to describe his/her own invention in the best way, it should be interpreted as meaning and concepts for complying with the technical idea of the present invention.

Thus, though the preferred embodiments of the present invention with drawings have been disclosed for illustrative purposes, those skilled in the art will appreciate that various modifications, additions and substitutions are possible.

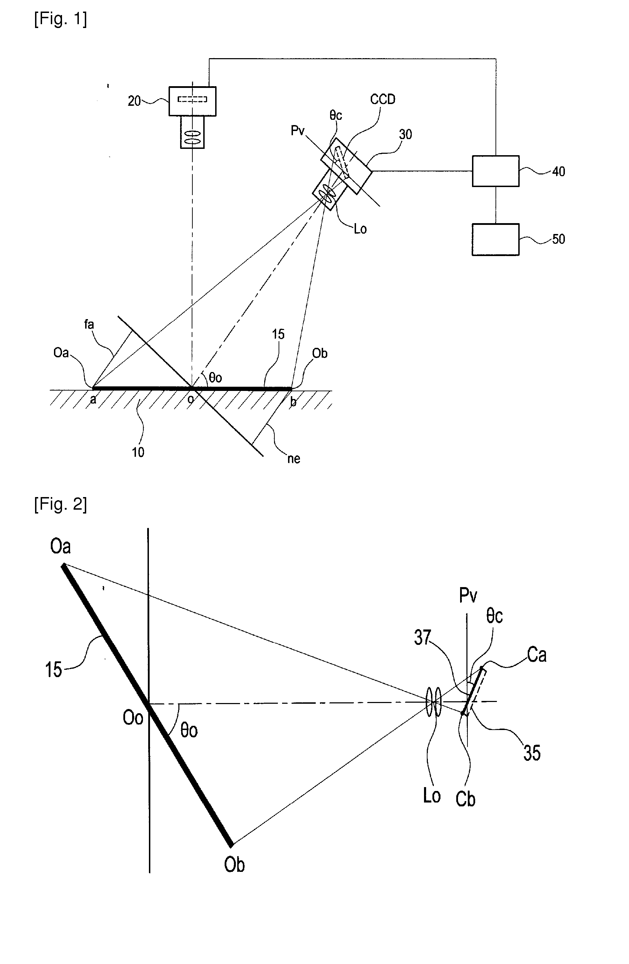

FIG. 1 is a schematic view of a visual inspection apparatus according to the present invention; and FIG. 2 is a conceptual view to describe the principle of the present invention.

With reference to FIG. 1 and FIG. 2, a visual inspection apparatus according to the present invention is an apparatus which photographs an inspection object 15 through a camera to determine whether the inspection object is defective or not. The vision inspection apparatus includes: a stage part 10 on which an inspection object is seated; camera parts 20 and 30 including a lens and an image detection part 35, wherein the camera parts photographs an image of the inspection object; an illumination part (not shown) of illuminating the inspection object; and a visual processing part 40 that reads the image photographed by the camera part to determine whether the inspection object is defective or not. A surface 37 of the image detection part 35 within a lateral camera 30 among the camera parts 20 and 30, which is slopingly installed with respect to the line perpendicular to the plane on which the inspection object 15 is seated, is slopingly installed at a predetermined angle θc with respect to the plane Pv perpendicular to the line of connecting the center Oo of the inspection object to the center Co of the camera lens within the lateral camera part 30.

When it inspects the surface mounting device of the printed circuit board in that the work is completed in the surface mounting line, the visual inspection apparatus according to the present invention is installed to be able to perform the visual inspection before moving to the next process through the conveyor of the previous equipment

Such the visual inspection apparatus can be installed in any method to be placed in the space formed between conveyors of the proceeding and following equipments; or can also be used in a solo table form that is not associated with the previous and following equipments.

The stage part 10 is configured to seat the inspection object on the PCB, which is a target of the visual inspection. For example, the inspection object 15 transported by means of the transfer of the robot arm, carrier rollers or motors and conveyor belt and the like through the control of the control unit 50 is seated thereon.

The camera parts 20 and 30 are configured to take a picture of two-dimensional geometry and a grid shadow of the inspection object. The lateral camera 30 is slopingly installed at a predetermined angle with respect to the inspection object 15.

The image detection part 35 included in the camera parts 20 and 30 consists of the imaging pickup device such as a charge coupled device (CCD) or a complementary metal-oxide semiconductor (CMOS).

The illumination part is configured to light up the illumination to the inspection object 15 and can include a grid part (not shown) in order to form the shadow of the grid shape.

Thus, the illumination is lightened through the grid part, so that the shadow of the grid part is formed on the surface of the inspection object 15 and the formed grid shadow is shot through the camera parts 20 and 30, and thus three-dimensional height of the inspection object is measured.

The illumination part lights up through the grid part and it shoots through the camera part 20 and 30, so that the grid line is taken a picture in the form of the parallel straight line in the part having the same three-dimensional height on the surface of the inspection object 15.

However, when the three-dimensional height on the surface of the inspection object 15 has different part, since the grid lines are distorted in the form of a discrepant type, the three-dimensional height of the inspection object 15 can be calculated through the degree of this distortion with trigonometric function.

A picture taken by the camera part 20 and 30 is read from the visual processing part 40 and the three-dimensional height of the surface of the inspection object 15 is calculated. When the height of the inspection object 15 is remarkably higher or lower than the height of the pre-stored reference data, for example, it is decided that the inspection object 15 such as the chip on the PCB substrate is not fitted correctly.

However, since a far side Oa from the lateral camera 30 among the edges of the inspection object 15 is placed in the longer distance than the center Oo of the inspection object 15 based on the distance from the image detection part 35 of the lateral camera 30, the depth of field thereof should be more secured as the degree of an approximate fa with respect to the center o of the inspection object 15. Also, since a near side Ob from the lateral camera 30 among the edges of the inspection object 15 is placed in the closer distance than the center Oo of the inspection object 15, the depth of field thereof should be secured as the degree of an approximate ne with respect to the center o of the inspection object 15, so that it is possible to photograph equably images for the entire area.

As described above, the difference of the depth of field required for photographing both edges of the inspection object more clearly is increased when the lateral camera 30 is inclined at a smaller angle than the stage part on which the inspection object is seated, i.e., when it is placed far away from the vertical camera 20.

By this phenomenon, the size of the depth of field should be increased in order to photograph of the entire object. The aperture of the camera narrows because the F value is increased when the depth of field is increased as the properties of the camera, resulting in a dark image. Thus, the resolution is reduced.

Thus, in the present invention, the depth of field with the lower F value of the camera is decreased and the image resolution is heightened to make the image illuminatingly, and instead, by compensating the optical path difference from the image detection part 35 to the inspection object, the entire images can be more clearly photographed.

By configuring as above, since the depth of field thereof is deteriorated, it does not need to secure the bigger lenses for photographing the entire inspection object.

According to the above purposes, the surface 37 of the image detection part 35 within the lateral camera 30 among the camera parts 20 and 30 is slopingly installed at a preset angle θc with respect to a plane Pv perpendicular to the line of connecting the center Lo of the camera in the lateral camera 30 to the center Oo of the inspection object.

Thus, the end portion Ca of the image detection part arranged symmetrically on the edge Ob of the inspection object, which is placed closely to the center Lo of the lens, is placed farther away from the center Lo of the lens and the end portion Cb of the image detection part symmetrically arranged on the edge Oa of the inspection object, which is placed closely to the center Lo of the lens, is placed farther away from the center Lo of the lens, thereby compensating for the optical path difference by means of the image detection part 35.

Thus, in order to reduce the optical path difference on both end portions of the inspection object as above, since it is unnecessary to increase the mounting angle of the lateral camera, the size of the apparatus is the same as that of the conventional visual inspection apparatus and the clearer images can be secured with the visual inspection apparatus of the present invention.

In addition, as described above, in order to compensate for the optical path difference with respect to both end portions of the inspection object, where the angle θo of the line of connecting the center Lo of the camera lens within the lateral camera to the center o of the inspection object with respect to a plane, on which the inspection object is placed, becomes smaller, the surface 37 of the image detection part is slopingly installed at a larger angle θc with respect to the plane Pv perpendicular to the line of connecting the center Lo of the camera lens in the lateral camera to the center of the inspection object.

Preferably, the surface 37 of the image detection part is slopingly installed at more than 2 degrees and less than 20 degrees with respect to the plane Pv perpendicular to the line of connecting the center of the camera lens in the lateral camera to the center o of the inspection object.

The surface 37 of the image detection part is a surface of a face-to-face side which accepts the light with the inspection object 15 in the image pickup device such as a CCD or CMOS.

The lateral camera 30 in the visual inspection apparatus is slopingly installed at an angle of 30 to 70 degrees with respect to the plane on which the inspection object is placed. For this installation state, it is preferred that the surface 37 of the image detection part with respect to the plane Pv perpendicular to the line of connecting the center of the camera lens in the lateral camera to the center of the inspection object is slopingly installed at more than 2 degrees and less than 20 degrees.

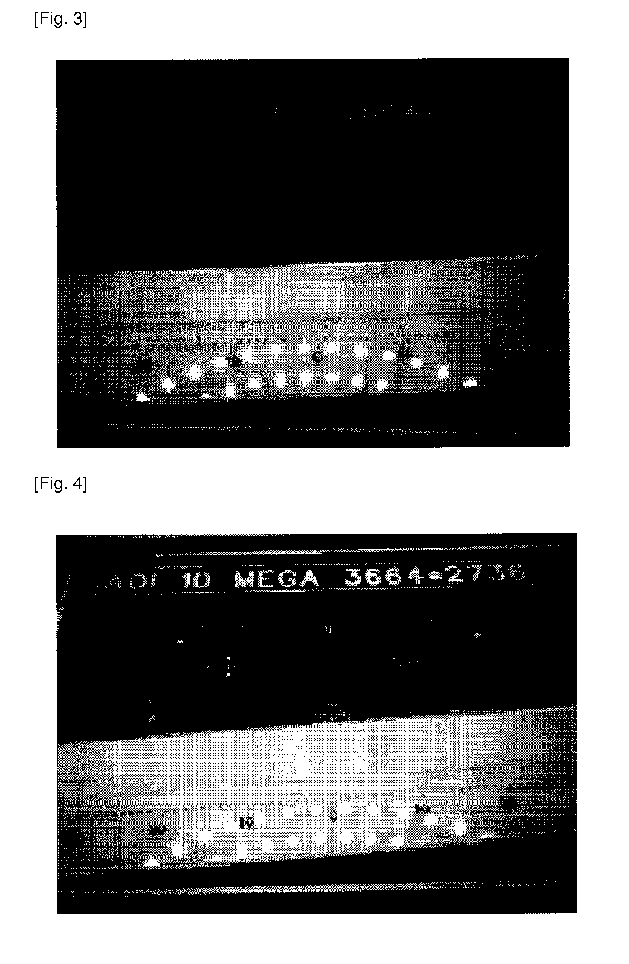

FIG. 3 is a film captured by a conventional visual inspection apparatus in high depth of field (F value increasing) and FIG. 4 is a film captured by a visual inspection apparatus according to the present invention, in that which the image detection part is slopingly installed in low depth of field (F value decreasing).

When it compares the captured images shown in FIG. 3 and FIG. 4, it can be found that the image captured by the visual inspection apparatus according to the present invention is brighter and clearer on the whole.

Although the preferred embodiments of the present invention with drawings have been disclosed for illustrative purposes, those skilled in the art will appreciate that various modifications, additions and substitutions are possible, without departing from the scope and spirit of the invention as disclosed in the accompanying claims.

## Claims

1. A visual inspection apparatus which photographs an inspection object through a camera to determine whether the inspection object is defective or not, comprising:
a stage part on which an inspection object is seated;
a camera part including a lens and an image detection part, wherein the camera part photographs an image of the inspection object;
an illumination part for illuminating the inspection object; and
a visual processing part that reads the image photographed by the camera part to determine whether the inspection object is defective or not, wherein, within a lateral camera of the camera part, which is slopingly installed with respect to a line perpendicular to a plane on which the inspection object is seated, a surface of the image detection part is slopingly installed at a predetermined angle with respect to a plane perpendicular to a line of connecting a center of the inspection object to a center of the camera lens of the lateral camera.

2. The visual inspection apparatus according to claim 1, wherein, with respect to a side end portion Ob of the inspection object placed on a side closer than the distance from the center Lo of the camera lens, a side end portion Cb of the image detection part is constituted to be placed more closely from the center Lo of the camera lens.

3. The visual inspection apparatus according to claim 2, wherein, where an angle θo of a line of connecting a center Lo of the camera lens in the lateral camera to a center o of the inspection object with respect to a plane, on which the inspection object is seated, becomes smaller, a surface 37 of the image detection part is slopingly installed in larger angle with respect to a plane Pv perpendicular to a line of connecting the center Lo of the camera lens in the lateral camera to the center of the inspection object.

4. The visual inspection apparatus according to claim 3, wherein the surface 37 of the image detection part is slopingly installed at more than 2 degrees and less than 20 degrees with respect to a plane Pv perpendicular to a line of connecting a center of the camera lens in the lateral camera to a center o of the inspection object.
